Europäisches Patentamt

European Patent Office

Office européen des brevets

(19)

(11) **EP 0 629 006 B1**

(12) **FASCICULE DE BREVET EUROPEEN**

(45) Date de publication et mention
de la délivrance du brevet:
**16.04.1997 Bulletin 1997/16**

(51) Int Cl.[6]: **H01L 39/20**, H01F 6/00

(21) Numéro de dépôt: **94400947.1**

(22) Date de dépôt: **02.05.1994**

(54) **Interrupteur supraconducteur et application à un chargeur de bobine supraconductrice**

Supraleitender Schalter und Anwendung als Speisung einer supraleitenden Spule

Superconducting switch and application to a superconducting coil load

(84) Etats contractants désignés:
**AT BE CH DE DK ES FR GB IE IT LI LU NL PT SE**

(30) Priorité: **05.05.1993 FR 9305367**

(43) Date de publication de la demande:
**14.12.1994 Bulletin 1994/50**

(73) Titulaire: **GEC ALSTHOM ELECTROMECANIQUE SA**
**75116 Paris (FR)**

(72) Inventeurs:
- **Estop, Pascal**
  **F-94400 Vitry sur Seine (FR)**
- **Poullain, Serge**
  **F-91700 Ste Geneviève des Bois (FR)**
- **Verhaege, Thierry**
  **F-91160 Saulx les Chartreux (FR)**

(74) Mandataire: **Fournier, Michel et al**
**c/o ALCATEL ALSTHOM,**
**Département de Propriété Industrielle,**
**30, avenue Kléber**
**75116 Paris (FR)**

(56) Documents cités:
**WO-A-94/03955**          **FR-A- 2 674 671**
**US-A- 3 444 307**          **US-A- 4 906 861**

- **PATENT ABSTRACTS OF JAPAN, vol. 12, no. 72 (E-588) 5 mars 1988; & JP-A-62 214 680**
- **PATENT ABSTRACTS OF JAPAN, vol. 13, no. 386 (E-812) 25 août 1989; & JP-A-01 136 317**
- **IEEE TRANSACTIONS ON MAGNETICS, vol. 27, no. 2, mars 1991, New York US, pages 2333-2336; G.B.J. MULDER et al.: 'Development of a thermally switched superconducting rectifier for 100 kA'**

## Description

La présente invention concerne un interrupteur supraconducteur.

On connaît par la revue IEEE Transactions on Magnetics volume 27 n°2 de mars 1991 pages 2333-2336, un dispositif redresseur double alternance comportant un bobinage primaire et deux bobinages secondaires disposés en parallèle et enroulés en sens inverse l'un de l'autre et reliés à une bobine supraconductrice pour la charger. Les bobinages secondaires sont chacun constitués de 1610 fils supraconducteurs reliés en parallèle, organisés en 230 bandes de 7 fils.

Les bandes sont réunies par groupe de 10 réalisant ainsi 23 groupes mis en parallèle de 7 X 10 fils en parallèles, constituant ainsi un conducteur supraconducteur unique.

Pour l'un des bobinages secondaire, ce conducteur est enroulé sur la surface externe d'un cylindre, en hélice, sur $\frac{11^{\grave{e}}}{23}$ de tour et pour l'autre, en sens inverse, sur $\frac{12^{\grave{e}}}{23}$ de tour sur la surface interne du cylindre à l'intérieur duquel se trouve le bobinage primaire.

Chacun des bobinages secondaires est équipé de deux éléments chauffants, sur une petite largeur, 5 mm, du conducteur formant ce bobinage : un sur chaque face du conducteur. Un élément chauffant est constitué par une pluralité de spires d'un fil de manganin.

Ces éléments chauffants servent à faire transiter alternativement les deux conducteurs supraconducteurs constituant les deux bobinages secondaires alimentant la bobine supraconductrice à charger.

On a ainsi un exemple d'un interrupteur supraconducteur. Cependant une telle disposition présente quelques inconvénients :

- la nécessité de placer des éléments chauffants alentour du conducteur rendent la mise en oeuvre des interrupteurs compliqués.
- les éléments chauffants et le conducteur supraconducteur n'étant pas au même potentiel électrique, une bonne isolation électrique entre ces organes est nécessaire.
- la nécessité d'avoir une bonne isolation thermique entre "l'interrupteur" et l'hélium, augmente le temps de recouvrement et donc, dans le cas de l'article ci-dessus où il s'agit d'un redresseur pour charger une bobine supraconductrice, diminue la fréquence possible de fonctionnement du redresseur. Ainsi, dans l'article cité, cette fréquence n'est que de 0,5 Hz.

L'invention a pour but de pallier ces inconvénients.

Un interrupteur supraconducteur composé d'une portion de câble comportant un brin central résistif autour duquel sont assemblés une pluralité de brins supraconducteurs séparés dudit brin central par un isolant électrique, l'ensemble étant isolé de l'extérieur, est connu du document JP-A-62-214680. Le brin central constitue un élément chauffant.

La solution au problème technique posé consiste, selon la présente invention, dans un interrupteur supraconducteur composé d'une portion de câble comportant un brin central résistif, non supraconducteur autour duquel sont assemblés en toron une pluralité de brins supraconducteurs, ou de conducteurs supraconducteurs, séparés dudit brin central par un isolant électrique, l'ensemble étant isolé de l'extérieur, milieu réfrigérant, par un isolant thermique, à chaque extrémité de ladite portion de câble, ledit brin central étant relié électriquement aux dits brins supraconducteurs ou aux conducteurs supraconducteurs, une portion de longueur dudit brin central résistif sortant dudit câble en un point de la longueur de ladite portion de câble et étant couplé à un dispositif de commande situé hors dudit milieu réfrigérant, ledit dispositif de commande consistant dans un moyen pour injecter un courant électrique dans le circuit formé par le brin central résistif relié à ses extrémités aux brins supraconducteurs ou aux conducteurs supraconducteurs.

Selon une réalisation particulière, ladite portion de longueur dudit brin central résistif sortie dudit câble est coupé, formant ainsi deux extrémités qui sont reliés audit dispositif de commande qui comprend un condensateur en série avec un interrupteur de décharge, une source de tension étant reliée aux bornes dudit condensateur par l'intermédiaire d'une résistance de charge et d'un interrupteur de charge.

L'invention a également pour objet un chargeur de bobine supraconductrice comportant, dans un milieu à température ambiante, une source de tension alternative reliée à un circuit redresseur à double alternance alimentant la bobine supraconductrice, le redresseur et la bobine étant situés dans un milieu réfrigérant, le circuit redresseur comportant un transformateur comprenant un bobinage primaire et un bobinage secondaire en deux parties, chaque partie étant reliée en parallèle à la bobine et l'alimentant alternativement par l'intermédiaire d'un moyen de commande assurant une demi-alternance sur deux la transition de l'état supraconducteur à l'état normal de la liaison de la partie considérée dudit bobinage secondaire avec la bobine, caractérisé en ce que ledit moyen de commande comprend un interrupteur supraconducteur tel que défini ci-dessus.

La figure 1, 2 et 3 représentent en section, trois exemples de câbles pouvant être utilisés pour réaliser un interrupteur supraconducteur selon l'invention.

La figure 4 montre un interrupteur supraconducteur selon l'invention.

La figure 5 est un schéma électrique symbolisant un interrupteur supraconducteur selon l'invention inséré dans une ligne supraconductrice et montrant un dispositif particulier de commande.

La figure 6 est un schéma électrique semblable à la figure 5 montrant une autre disposition pour le dispositif de commande.

La figure 7 est un schéma électrique représentant un chargeur de bobine avec des interrupteurs supraconducteurs commandés conformément à la figure 5.

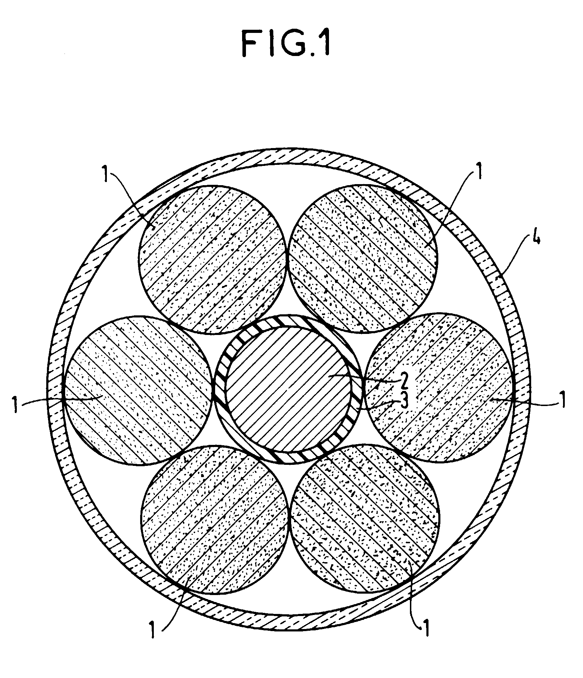

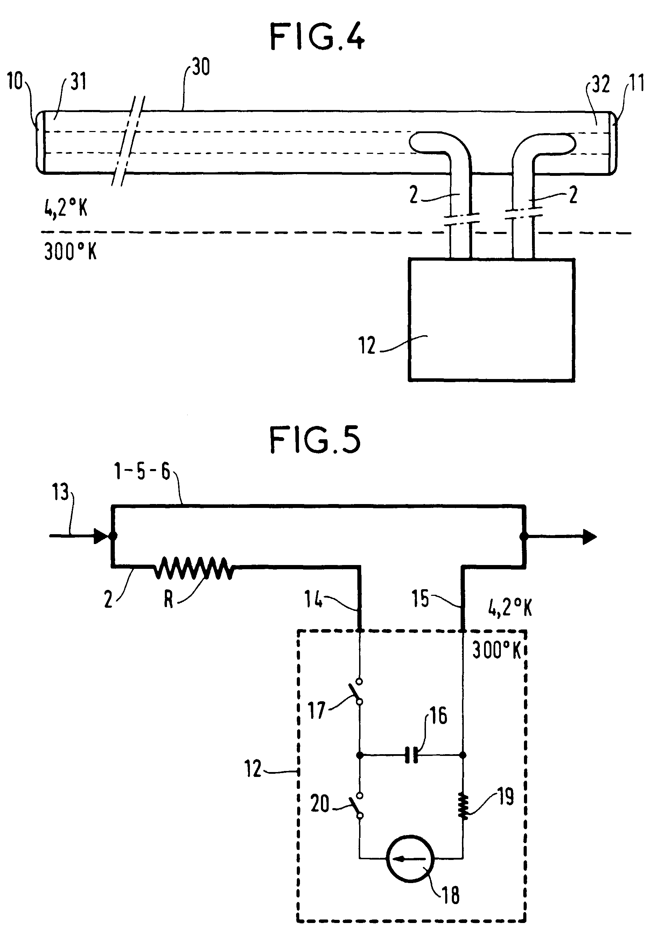

En se reportant à la figure 1, on voit la section d'un câble tel qu'il peut être utilisé pour réaliser un interrupteur supraconducteur conforme à l'invention et représenté sur les figures 4, 5 et 6.

Le câble représenté est composé de six brins supraconducteurs 1, constitués chacun de filaments de Niobium titane (NbTi) noyés dans une matrice en Cupro Nickel (CuNi), assemblés en toron autour d'un brin central résistif, non supraconducteur 2.

Ce brin central 2 peut être constitué soit de CuNi, soit de CuNi contenant des filaments de cuivre (Cu), il est séparé des six brins supraconducteurs 1 par un isolant électrique 3. Cet isolant 3 est de préférence un bon conducteur thermique afin de permettre à la chaleur dégagée dans le brin central 2 par effet Joule de diffuser rapidement dans les brins supraconducteurs 1. Un matériau répondant bien à ces conditions : isolation électrique et bonne conduction thermique est le Nitrure d'Aluminium ou tout matériau analogue.

Ainsi, l'isolant 3 est par exemple constitué d'une résine chargée en Nitrure d'Aluminium. L'ensemble du câble est isolé par un isolant thermique 4. En effet la portion de longueur d'un tel câble, utilisé comme interrupteur supraconducteur, est situé, en fonctionnement, dans un milieu réfrigérant tel que de l'hélium liquide à 4,2 °K. Cette isolation thermique 4 doit être suffisante pour limiter la puissance nécessaire au réchauffement des brins supraconducteurs 1 par la puissance dissipée dans le brin central 2 mais doit également être minimisée de façon à permettre une récupération de l'état supraconducteur (par refroidissement des brins supraconducteurs) en des temps compatibles avec des fonctionnements à fréquences élevées telles que 50 Hz.

Dans le cas de fonctionnement à des fréquences plus faibles, cette isolation 4 peut être plus forte.

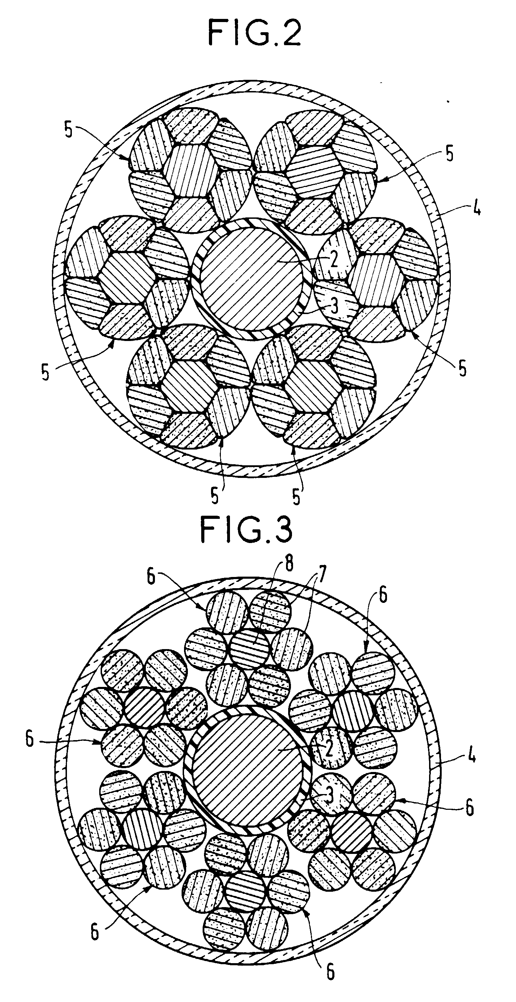

La figure 2 montre un autre exemple d'un câble pouvant être utilisé pour faire un interrupteur supraconducteur.

Ici, le câble est constitué de six conducteurs supraconducteurs 5 assemblés en toron autour d'un brin central résistif 2 non supraconducteur et séparés de ce dernier par un isolant électrique 3, l'ensemble étant isolé par un isolant thermique 4. Un exemple de conducteur supraconducteur tel que 5 est décrit dans le document de brevet FR-A-2674671.

La figure 3 montre encore un autre exemple de câble utilisable pour faire un interrupteur supraconducteur selon l'invention.

Le câble est constitué, comme dans la figure 2, de six conducteurs supraconducteurs 6 assemblés en toron autour d'un brin central résistif 2, non supraconducteur, et séparés de ce dernier par un isolant électrique 3, l'ensemble étant isolé par un isolant thermique 4.

Dans cette figure, les divers composants des conducteurs 6 : brins supraconducteurs 7 et brin central 8 ont une section circulaire.

La figure 4 représente un interrupteur supraconducteur selon l'invention :

Un tel interrupteur se compose d'une portion de longueur d'un câble 30 du type tel que décrit en référence aux figures 1, 2 ou 3.

A chaque extrémité 31, 32 du câble, les brins supraconducteurs 1, dans le cas du câble de la figure 1, ou les conducteurs supraconducteurs 5 ou 6 dans le cas du câble des figures 2 ou 3, sont connectés en parallèle au brin central résistif 2.

Cette connexion peut être effectuée par exemple par soudure 10, 11.

En outre, en un point de la longueur de la portion de câble 30, le brin central résistif 2 est désolidarisé des brins supraconducteurs 1, ou des conducteurs supraconducteurs 5 ou 6, et sort à l'extérieur du câble 30 et, après traversée du milieu réfrigérant à 4,2°K où se trouve le câble, est couplé à un dispositif de commande 12 situé en milieu ambiant aux environs de 300°K. Le rôle de ce dispositif de commande est d'injecter un courant électrique dans le circuit formé par le brin central résistif 2 en parallèle avec les brins supraconducteurs 1 (ou les conducteurs supraconducteurs 5 ou 6).

Le passage de ce courant dans le brin central résistif 2 produit un échauffement de ce dernier par effet Joule sur toute la longueur de la portion de câble 30. La chaleur ainsi dégagée diffuse ensuite dans les brins supraconducteurs 1 (ou les conducteurs supraconducteurs 5 ou 6), provoquant leur passage à l'état normal lorsque la température critique est atteinte : 10 à 11° K.

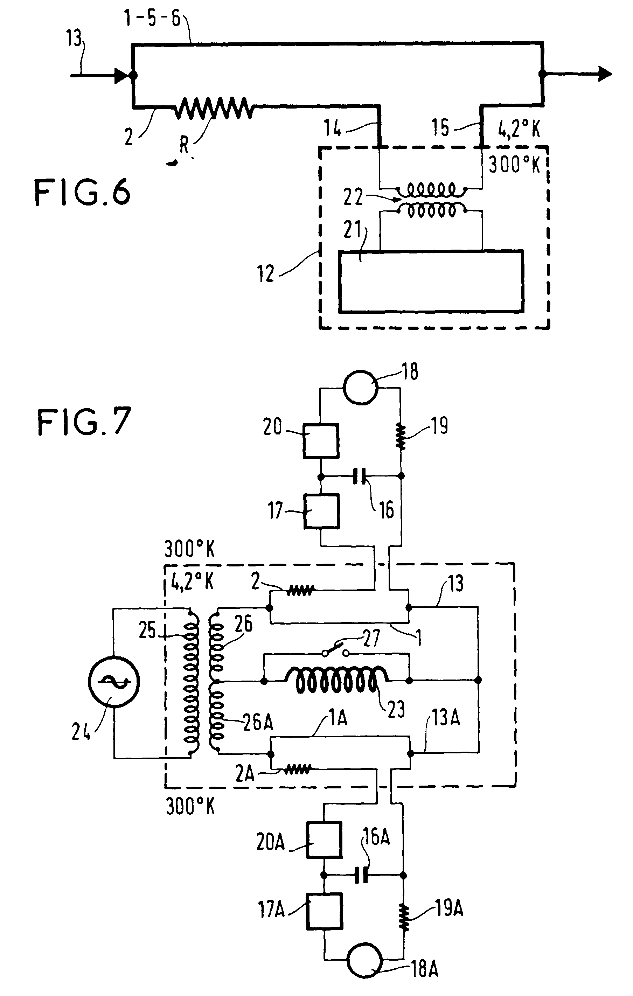

La figure 5 est un schéma électrique qui représente l'interrupteur de la figure 4 inséré dans une ligne de courant 13 et dans laquelle un dispositif de commande 12, particulier, est représenté.

L'interrupteur est représenté par un circuit en parallèle comportant les brins supraconducteurs 1 (ou les conducteurs supraconducteurs 5, 6) figurés par un fil unique et le brin central résistif 2 figuré par un fil comportant une résistance R.

Le brin résistif 2 est coupé et ses extrémités 14, 15 sont reliées au dispositif de commande 12 situé à la température ambiante de 300°K. Ce dispositif comprend un condensateur 16 disposé en série avec un interrupteur de décharge 17. Aux bornes du condensateur 16, est situé une source de tension 18 en série avec une résistance de charge 19 et un interrupteur de charge 20.

Le fonctionnement est le suivant : Dans la première phase de fonctionnement, le condensateur 16 est chargé par la fermeture de l'interrupteur 20, l'interrupteur 17 étant ouvert. Le condensateur se charge alors à travers la résistance 19 jusqu'à la tension de charge de la source 18 stockant ainsi de l'énergie. L'interrupteur 20 est alors ouvert et le circuit est en phase d'attente. Lors de la commande pour la commutation du circuit ou "fermeture de l'interrupteur", l'interrupteur 17 est fermé, le condensateur 16 se décharge alors dans le circuit formé du brin central résistif 2 et des brins supraconducteurs 1 (ou des conducteurs supraconducteurs 5 ou 6). Le passage du courant dans le brin résistif 2, assimilé à la résistance R, dégage de la chaleur par effet Joule qui diffuse dans les brins supraconducteurs 1, (5 ou 6) provoquant leur transition vers l'état normal non supraconducteur.

Les interrupteurs 17 et 20 peuvent, bien entendu, être des interrupteurs commandés à thyristors, ou à transistors, permettant un fonctionnement du dispositif à la fréquence désirée.

Le recouvrement à l'état supraconducteur des brins 1 (ou 5 ou 6) se fait tout seul par refroidissement de ces brins par le milieu réfrigérant à 4,2°K dans lequel se trouve le circuit, dès que le courant de décharge du condensateur 17 à cessé.

La figure 6 montre un autre dispositif de commande 12 qui génère par une commande appropriée 21 du primaire d'un transformateur 22, un créneau de tension aux bornes du secondaire dudit transformateur 22 reliées aux extrémités 14 et 15.

Enfin, la figure 7 montre une application du dispositif interrupteur, il s'agit d'un chargeur d'une bobine supraconductrice 23.

En effet, la charge directe d'une bobine supraconductrice sous des courants importants génère des pertes cryogéniques qui peuvent devenir très importantes avec des forts courants à travers les amenées de courant. Le rôle des amenées de courant est de véhiculer le courant, depuis la source, qui est à température ambiante d'environ 300°K, à la bobine supraconductrice qui est à la température de l'hélium liquide : 4,2°K.

L'utilisation d'un chargeur de bobine permet une réduction considérable de ces pertes.

Ce chargeur de bobine comprend une source de tension alternative 24, située à température ambiante d'environ 300°K, reliée à un circuit redresseur à double alternance comportant un transformateur dont le bobinage primaire 25 a un grand nombre de spires $N_1$ et dont le secondaire est en deux parties 26 et 26A qui ont un nombre de spires N2 très inférieur à celui du bobinage primaire. Chaque enroulement secondaire 26 et 26A est relié en parallèle à la bobine 23 par l'intermédiaire d'un moyen de commande, consistant en un interrupteur et son dispositif de commande conforme à celui de la figure 5, assurant, une demi-alternance sur deux, la transition de l'état supraconducteur à l'état normal des brins supraconducteurs 1 (ou des conducteurs supraconducteurs 5 ou 6). Dans la figure, on a affecté d'un indice A les références du moyen de commande situées du côté du bobinage secondaire 26A.

Bien entendu, une alternance sur deux c'est le bobinage 26 qui alimente la bobine 23, "l'interrupteur" correspondant étant fermé et l'autre, celui avec les indices A, ouvert, et l'autre alternance, c'est le bobinage 26A qui alimente la bobine 23, "l'interrupteur" correspondant étant fermé et l'autre, celui sans indices, ouvert.

Les interrupteurs 17, 20, 17A et 20A sont des interrupteurs électroniques commandés, par exemple à thyristors.

Comme le rapport du nombre de spires $\frac{N_1}{N_2}$ est élevée, le courant primaire dans le bobinage 25 est très inférieur à celui des bobinages secondaires 26 et 26A qui lui est égal au courant de charge de la bobine 23.

Ainsi, les amenées de courant provenant de l'extérieur et qui traversent le milieu cryogénique à 4,2°K véhiculant un courant très inférieur au courant de charge, il en résulte que les pertes engendrées dans ces amenées sont fortement réduites.

A chaque alternance, la bobine est alimentée soit par le bobinage 26 soit par le bobinage 26A et le courant dans la bobine augmente d'une certaine valeur. En fait, à chaque alternance, une certaine quantité d'énergie est transférée du circuit primaire vers la bobine 23.

Une fois la bobine chargée, un interrupteur supraconducteur 27 est fermé court-circuitant les deux extrémités de la bobine qui stocke ainsi une certaine énergie.

Le dispositif décrit dans la présente invention permet un fonctionnement à 50 Hz et est donc particulièrement intéressant dans le cas d'une application à un chargeur de bobine.

Pour cela, un interrupteur tel que celui représenté figure 5 avec sa commande, doit avoir un temps d'ouverture (passage des brins 1, ou des conducteurs 5 ou 6, de l'état supraconducteur à l'état normal) de l'ordre 1ms et un temps de fermeture (recouvrement de l'état supraconducteur) de 2 à 3 ms.

Le tableau ci-après donne quelques exemples de câbles, du type décrit figure 1 avec une isolation du brin central par émaillage, permettant ces caractéristiques :

| Diamètre d'un brin supraconducteur 1 | Diamètre du brin central 2 | Epaisseur de l'isolation 3 du brin central 2 | Epaisseur de l'isolation 4 |
|---|---|---|---|
| 0,3 mm | 0,25 mm | 0,025 mm | 0,05mm |
| 0,2 mm | 0,15 mm | 0,025 mm | 0,1 mm |
| 0,2 mm | 0,15 mm | 0,025 mm | 0,05 mm |

**Revendications**

1. Interrupteur supraconducteur composé d'une portion de câble (30) comportant un brin central résistif (2), non supraconducteur autour duquel sont assemblés en toron une pluralité de brins supraconducteurs (1), ou de conducteurs supraconducteurs (5, 6), séparés dudit brin central par un isolant électrique (3), l'ensemble étant isolé de l'extérieur, milieu réfrigérant, par un isolant thermique (4), à chaque extrémité (31, 32) de ladite portion de câble (30), ledit brin central (2) étant relié électriquement auxdits brins supraconducteurs, ou aux conducteurs supraconducteurs, une portion de longueur dudit brin central résistif sortant dudit câble en un point de la longueur de ladite portion de câble et étant couplée à un dispositif de commande (12) situé hors dudit milieu réfrigérant, ledit dispositif de commande consistant dans un moyen pour injecter un courant électrique dans le circuit formé par le brin central résistif (2) relié à ses extrémités aux brins supraconducteurs (1) ou aux conducteurs supraconducteurs (5, 6).

2. Interrupteur supraconducteur selon la revendication 1 caractérisé en ce que ladite portion de longueur dudit brin central résistif (2) sortie dudit câble est coupée, formant ainsi deux extrémités (14, 15) qui sont reliées audit dispositif de commande (12) qui comprend un condensateur (16) en série avec un interrupteur de décharge (17), une source de tension (18) étant reliée aux bornes dudit condensateur (16) par l'intermédiaire d'une résistance de charge (19) et d'un interrupteur de charge (20).

3. Interrupteur supraconducteur selon la revendication 2, caractérisé en ce que ledit interrupteur de charge (20) et ledit interrupteur de décharge (17) sont des interrupteurs électroniques commandés.

4. Interrupteur supraconducteur selon la revendication 1 caractérisé en ce que ladite portion de longueur dudit brin central résistif sortie est coupée, formant ainsi deux extrémités (14, 15) qui sont reliées audit dispositif de commande (12) générant, par une commande (21) du primaire d'un transformateur (22), un créneau de tension aux bornes du secondaire dudit transformateur reliés aux dites extrémités (14, 15).

5. Chargeur de bobine supraconductrice (23) comportant, dans un milieu à température ambiante, une source de tension alternative (24) reliée à un circuit redresseur à double alternance alimentant la bobine supraconductrice (23), le redresseur et la bobine (23) étant situés dans un milieu réfrigérant, le circuit redresseur comportant un transformateur comprenant un bobinage primaire (25) et un bobinage secondaire en deux parties (26, 26A) chaque partie étant reliée en parallèle à la bobine (23) et l'alimentant alternativement par l'intermédiaire d'un moyen de commande assurant une demi-alternance sur deux la transition de l'état supraconducteur à l'état normal de la liaison de la partie considérée dudit bobinage secondaire avec la bobine, caractérisé en ce que ledit moyen de commande comprend un interrupteur supraconducteur selon l'une des revendications 1, 3 ou 4.

**Patentansprüche**

1. Supraleitender Schalter, bestehend aus einem Kabelstück (30), das eine zentrale, nicht-supraleitende Ader (2) mit Widerstandseigenschaften sowie um diese herumgewunden mehrere supraleitende Adern (1) oder Supraleiter (5, 6) aufweist, die gegenüber der zentralen Ader durch eine elektrische Isolierung (3) getrennt sind, während das Ganze nach außen, d.h. gegen das Kühlmittel, durch eine Wärmeisolierung (4) isoliert ist, wobei an jedem Ende (31, 32) des Kabelstücks (30) die zentrale Ader (2) elektrisch mit den supraleitenden Adern oder den Supraleitern verbunden ist und ein Teil der Länge der zentralen Ader mit Widerstandseigenschaften aus dem Kabel an einer Stelle entlang des Kabelstücks hervorsteht und an eine Steuervorrichtung (12) außerhalb des Tiefsttemperatur-

5

milieus gekoppelt ist, die aus einem Mittel besteht, um einen elektrischen Strom in den von der zentralen Ader (2) mit Widerstandseigenschaften und den an den Enden angeschlossenen supraleitenden Adern (1) oder Supraleitern (5, 6) gebildeten Schaltkreis einzuspeisen.

2.  Supraleitender Schalter nach Anspruch 1, dadurch gekennzeichnet, daß der Teil der Länge der zentralen Ader (2) mit Widerstandseigenschaften, der aus dem Kabel hervorsteht, aufgeschnitten ist und so zwei Enden (14, 15) bildet, die an die Steuervorrichtung (12) angeschlossen ist, welche einen Kondensator (16) in Reihe mit einem Entladungsschalter (17) enthält, während eine Spannungsquelle (18) an die Klemmen des Kondensators (16) über einen Ladewiderstand (19) und einen Ladeschalter (20) angeschlossen ist.

3.  Supraleitender Schalter nach Anspruch 2, dadurch gekennzeichnet, daß der Ladeschalter (20) und der Entladeschalter (17) gesteuerte elektronische Schalter sind.

4.  Supraleitender Schalter nach Anspruch 1, dadurch gekennzeichnet, daß der Teil der aus dem Kabel vorstehenden Länge der zentralen Ader mit Widerstandseigenschaften aufgeschnitten ist und damit zwei Enden (14, 15) bildet, die an die Steuervorrichtung (12) angeschlossen sind, wobei die Steuervorrichtung durch eine Steuerung (21) der Primärwicklung eines Transformator (22) einen Spannungsimpuls an den an diese Enden (14, 15) angeschlossenen Klemmen der Sekundärwicklung des Transformator erzeugt.

5.  Ladeschaltung für eine supraleitende Spule (23) mit einer Wechselspannungsquelle (24) bei Umgebungstemperatur, die an eine Zweiweg-Gleichrichterschaltung zur Speisung der supraleitenden Spule (23) angeschlossen ist, wobei die Gleichrichterschaltung und die Spule (23) in einem Kühlmittel liegen und die Gleichrichterschaltung einen Transformator mit einer Primärwicklung (25) und einer aus zwei Teilen (26, 26A) bestehenden Sekundärwicklung enthält, wobei jeder dieser Teile parallel an die Spule (23) angeschlossen ist und diese Spule abwechselnd über ein Steuermittel speist, das während jeder zweiten Halbwelle den Übergang der Verbindung des betreffenden Teils der Sekundärwicklung mit der Spule aus dem supraleitenden in den normalleitenden Zustand bewirkt, dadurch gekennzeichnet, daß das Steuermittel einen supraleitenden Schalter (1, 2, 1A, 2A) gemäß einem der Ansprüche 1, 3 oder 4 enthält.

## Claims

1.  A superconducting switch comprising a portion of cable (30) including a resistive central strand (2) that is non-superconducting having a plurality of superconducting strands (1) or of superconductors (5, 6) twisted thereabout, and separated from the central strand by electrical insulation (3), the cable as a whole being insulated from the external cooling medium by thermal insulation (4), said central strand (2) being electrically connected to said superconducting strands or said superconductors at each end (31, 32) of said portion of cable (30), a portion of the length of said resistive central strand extending outside said cable at a point along the length of said portion of said cable and being coupled to a control device (12) situated outside said cooling medium, said control device consisting in means for injecting an electrical current into the circuit formed by the resistive central strand (2) that is connected at its ends to the superconducting strands (2) or to the superconductors (5, 6).

2.  A superconducting switch according to claim 1, characterized in that said portion of the length of said resistive central strand (2) outside said cable is cut, thereby forming two ends (14, 15) which are connected to said control device (12) that comprises a capacitor (16) in series with a discharge switch (17), a voltage source (18) being connected across the terminals of said capacitor (16) via a charging resistor (19) and a charging switch (20).

3.  A superconducting switch according to claim 2, characterized in that said charging switch (20) and said discharge switch (17) are controlled electronic switches.

4.  A superconducting switch according to claim 1, characterized in that said portion of the length of said extracted resistive central strand is cut, thereby forming two ends (14, 15) which are connected to said control device (12) which, by controlling (21) the primary winding of the transformer (22), generates a voltage pulse across the terminals of the secondary winding of said transformer which are connected to said ends (14, 15).

5.  A charger for a superconducting coil (22), the charger comprising, an AC voltage source (24) in a medium at ambient temperature and connected to a full-wave rectifier circuit feeding the superconducting coil (23), the rectifier and the coil (23) being situated in a refrigerating medium, the rectifier circuit comprising a transformer having a primary winding (25) and a secondary winding in two portions (26, 26A), each portion being connected in parallel with the coil (23) and feeding it alternately via control means that operate every other half-cycle to cause the connection between the corresponding portion of said secondary winding and the coil to switch from the superconducting state to the normal state, the charger being characterized in that each of said control means comprises a superconducting switch (1, 2, 1A, 2A) according to any one of claims 1, 2, 3, or 4.

# FIG.1

## FIG.2

## FIG.3

# FIG.4

4,2°K

300°K

# FIG.5

**FIG.6**

**FIG.7**